# EUROPÄISCHE PATENTANMELDUNG

(11) **EP 3 261 118 A1**
(43) Veröffentlichungstag der Anmeldung: **27.12.2017**
(21) Anmeldenummer: 17177893.9
(22) Anmeldetag: 06.11.2014
(51) Int. Cl.: H01L 23/34, H01L 23/473, H01L 23/367, F28F 3/02, H01L 21/48, H05K 7/20, F28F 13/08, H01L 23/467

(54) **KÜHLKÖRPER**

(30) Priorität: 06.11.2013 DE 202013104990 U
(62) Teilanmeldung aus: 16178495.4
(71) Anmelder: AKG Thermotechnik International GmbH & Co. KG, 34369 Hofgeismar (DE)
(72) Erfinder: KOZICA, Michael, 34376 Immenhausen (DE); WIELEKE, Fabian, 34246 Vellmar (DE); ZINN, Thomas, 34125 Kassel (DE)
(74) Vertreter: Specht, Peter

(57) **Zusammenfassung**

Ein Kühlkörper (2) für mindestens ein zu kühlendes Bauelement (1), insbesondere ein Halbleiterbauelement, weist mehrere nebeneinander angeordnete, Kühlluftkanäle (140) bildende Kühlrippen (110, 130) auf, die mit jeweiligen ersten Enden (41, 51) eine Grundplatte bilden, wobei zumindest einige der Kühlrippen (110, 130) ein gegenüber einem die Kühlluftkanäle (140) bildenden Bereich (112) verdicktes erstes Ende (111) aufweisen, wobei ein Teil der Kühlrippen (110) als Strangpressprofil und die übrigen Kühlrippen (130) als Trennbleche ausgebildet sind, wobei die Strangpressprofile und die Trennbleche (130) miteinander verlötet sind und wobei an den als Strangpressprofil ausgebildeten Kühlrippen (110) in Kühlluftströmungsrichtung (x) sich erstreckende Stege (113, 114) im die Kühlluftkanäle (140) bildenden Bereich (112) angeformt sind, die an jeweiligen Seitenflächen der als Trennbleche ausgebildeten Kühlrippen (130) anliegen.

## Beschreibung

Die vorliegende Erfindung betrifft einen Kühlkörper für mindestens ein zu kühlendes Bauelement, insbesondere ein Halbleiterbauelement, gemäß dem Oberbegriff des Anspruchs 1.

Gattungsgemäße Kühlkörper zur Kühlung von insbesondere elektronischen Hochleistungsbauteilen wie beispielsweise IGBT-Baugruppen für Stromrichter, beispielsweise bekannt aus der DE 10 2006 019 376 A1, der DE 43 22 647 A1 oder der DE 93 04 128 U1 dienen dazu, die von diesen Bauelementen erzeugte Wärme abzuleiten und dadurch die Bauelemente zu kühlen.

Die Kühlkörper bestehen dabei in der Regel aus einer Grundplatte, auf der eines oder mehrere dieser Bauteile flächig aufgebracht sind, und einer dieser Bauelementfläche abgewandten Kühlkörperfläche, von der sich Kühlluftkanäle bildende Kühlrippen weg erstrecken. Diese Kühlrippen sind dabei in einer Variante in Nuten einer beispielsweise als Strangpressprofil ausgebildeten Grundplatte eingelassen, so dass die von den Bauteilen erzeugte Wärme durch die Grundplatte in die Kühlrippen geleitet wird und die Kühlrippen ihrerseits unter Ausbildung der oben genannten Kühlluftkanäle bei Durchleitung von Kühlluft durch den Kühlkörper diese Wärme an die durchgeleitete Kühlluft abgeben.

Zur Erzielung einer möglichst hohen Leistung dieser Kühlkörper, sprich einer möglichst effektiven Wärmeabfuhr, ist zum einen eine hohe Rippendichte mit möglichst dünnwandigen Rippenkörper erwünscht, zum zweiten sollte der Druckverlust der Kühlluft beim Durchleiten durch den Kühlkörper möglichst gering sein. Schließlich sollte die Kühlleistung des Kühlkörpers in Kühlluft-Strömungsrichtung durch den Kühlkörper möglichst konstant sein, um auch bei beispielsweise in Kühlluftströmungsrichtung hintereinander gebauten zu kühlenden Bauteilen auch die hinteren Bauteile noch hinreichend kühlen zu können.

Aufgabe der vorliegenden Erfindung ist es, einen Kühlkörper bereitzustellen, mit dem die oben genannten Probleme möglichst effektiv und kostengünstig gelöst werden.

Diese Aufgabe wird durch einen Kühlkörper mit den Merkmalen des Anspruchs 1 gelöst.

Der mit Anspruch 1 beanspruchte Aufbau eines Kühlkörpers besteht im Wesentlichen aus einer Vielzahl nebeneinander angeordneter, Kühlluftkanäle bildender Kühlrippen, die mit jeweiligen ersten Enden eine Grundplatte bilden, wobei zumindest einige der Kühlrippen ein gegenüber einem die Kühlluftkanäle bildenden Bereich verdicktes erstes Ende aufweisen, wobei ein Teil der Kühlrippen als Strangpressprofil und die übrigen Kühlrippen als Trennbleche ausgebildet sind, wobei die Strangpressprofile und die Trennbleche hintereinander verlötet sind. An den als Strangpressprofil ausgebildeten Kühlrippen sind in Kühlluft-Strömungsrichtung sich erstreckende Stege im die Kühlluftkanäle bildenden Bereich angeformt, die an jeweiligen Seitenflächen der als Trennbleche ausgebildeten Kühlrippen anliegen

Mit diesem Aufbau eines Kühlkörpers ist ein kostengünstig herzustellender Kühlkörper bereitgestellt, bei dem die aus den verdickten Enden der Kühlrippen zusammengesetzten Grundplatten durch die Verlötung eine gut wärmeleitende Grundplatte bilden. Ein solcher Kühlkörper lässt sich außerdem in einfacher und kostengünstiger Weise zu einem Block zusammenfügen und löten, wodurch der Kühlkörper in seinen Abmessungen auch sehr variabel gestaltet werden kann, da die Herstellung eines Kühlkörpers größerer Länge oder Breite in einfacher Weise dadurch realisiert werden kann, dass mehr oder weniger Strangpressrippen und Trennbleche zusammengefügt werden. Bei Strangpress-Kühlkörpern mit Strangpressgrundplatten müssen hingegen meist Werkzeuge mit der gewünschten Breite gefertigt werden, was mit größeren Herstellungskosten einhergeht.

Die Stege ermöglichen einen guten Wärmeaustausch zwischen den als Strangpressprofil ausgebildeten Kühlrippen und den als Trennbleche ausgebildeten Kühlrippen.

Diese Stege sind dabei bevorzugt beidseitig des die Kühlluftkanäle bildenden Bereiches angeformt.

Gemäß einer bevorzugten Ausführungsvariante des erfindungsgemäßen Kühlkörpers sind die Stege um einen halben Abstand, in dem die Stege parallel zueinander auf einer Seite des Strangpressprofils angeformt sind, zueinander versetzt wechselseitig an den als Strangpressprofil ausgebildeten Kühlrippen angeformt.

Besonders bevorzugt ist die Länge der Stege senkrecht zur Kühlluft-Strömungsrichtung größer als die Hälfte der Differenz der Dicke des verdickten Endes der als Strangpressprofil ausgebildeten Kühlrippen und der Dicke des Kühlluftkanäle bildenden Bereichs der als Strangpressprofil ausgebildeten Kühlrippen, so dass bei Zusammensetzen des Kühlkörpers die Trennbleche geringfügig verformt werden und somit auch bei Fertigungstoleranzen der Strangpressprofile und der Abstandsrippen eine mechanische Anlage der Stege zu den Trennblechen gewährleistet ist und damit eine wärmeleitende Verbindung erzeugt werden kann.

Gemäß einer weiteren vorteilhaften Ausführungsvariante dieses Kühlkörpers sind die Kühlluftkanäle bildenden Bereiche der als Trennbleche ausgebildeten Kühlrippen im Kühlluft-Eintrittsbereich des Kühlkörpers zumindest teilweise weggeschnitten, was, wie bereits oben beschrieben, eine vorteilhaften Reduzierung des Druckverlusts der Kühlluft beim Durchströmen des Kühlkörpers ermöglicht.

Nachfolgend werden Ausführungsbeispiele der Erfindung anhand der beiliegenden Zeichnungen näher erläutert. Es zeigen:
- Figur 1: eine schematische Teilexplosionsdarstellung einer Ausführungsvariante eines Kühlkörpers, bestehend im Wesentlichen aus einem Stapel nebeneinander angeordneter als Trennbleche bzw. Strangpressprofile ausgebildeten Kühlrippen,
- Figur 2: eine perspektivische Teilexplosionsdarstellung einer Variante des in Figur 1 gezeigten Kühlkörpers mit teilweise weggeschnittenem Bereich des Trennbleches,
- Figur 3: eine schematische Teilexplosionsdarstellung einer weiteren Ausführungsvariante des Kühlkörpers aus Figur 1 mit einem oberen und einem unteren verdickten Bereich der als Strangpressprofil ausgebildeten Kühlrippen, und
- Figur 4: eine perspektivische Ansicht eines Ausschnitts des Kühlkörpers aus Figur 1 mit an den Wänden angeformten Stegen einer Länge, bei der im zusammengesetzten Zustand die Trennbleche leicht verformt werden.

In der nachfolgenden Figurenbeschreibung beziehen sich Begriffe wie oben, unten, links, rechts, vorne, hinten usw. ausschließlich auf die in den jeweiligen Figuren ausgewählte beispielhafte Darstellung und Position des Kühlkörpers, der Grundplatte, Kühlrippen, Kühlluftkanäle, Stege und dergleichen. Diese Begriffe sind nicht einschränkend zu verstehen, d. h., durch verschiedene Arbeitsstellungen oder die spiegelsymmetrische Auslegung oder dergleichen können sich diese Bezüge ändern.

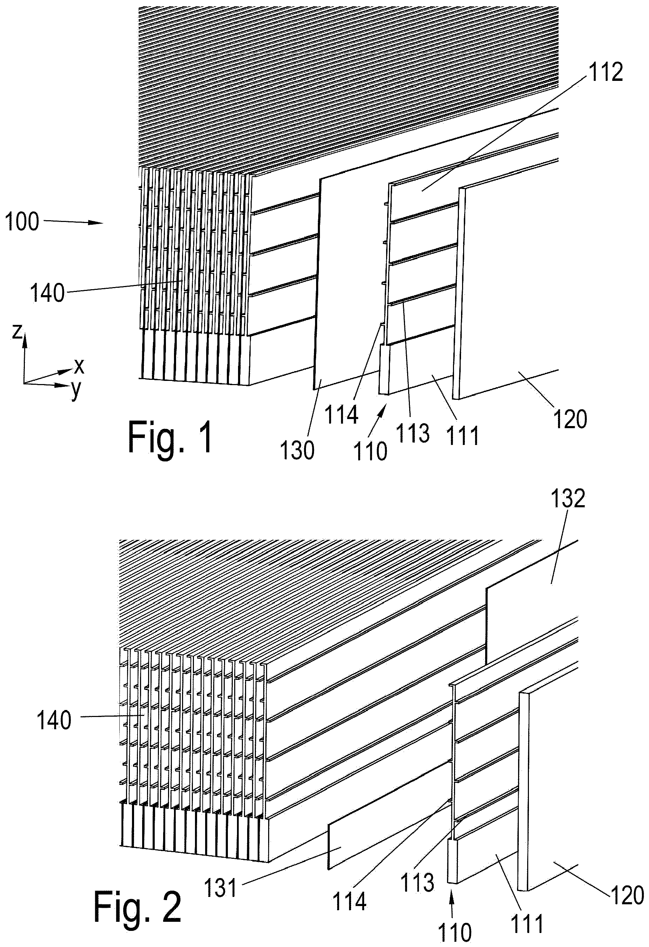

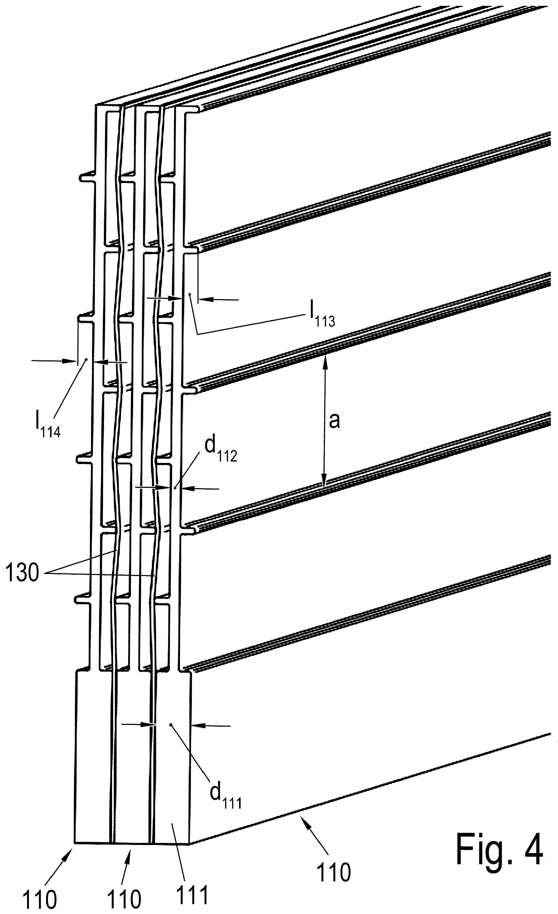

Eine erste Ausführungsvariante eines erfindungsgemäßen Kühlkörpers 100 ist in den Figuren 1 bis 4 dargestellt. Der Kühlkörper 100 besteht bei dieser Ausführungsvariante im Wesentlichen aus einer Vielzahl nebeneinander angeordneten Kühlluftkanäle 140 bildenden Kühlrippen 110, 130, die mit jeweiligen ersten Enden 111, 131 eine Grundplatte bilden, wobei zumindest einige der Kühlrippen 110, 130 ein gegenüber einem die Kühlluftkanäle 140 bildenden Bereiche 112 verdicktes sich in Kühlluftströmungsrichtung x erstreckendes erstes Ende 111 oder Randbereich aufweisen. Die Kühlrippen 110, 130 sind dabei teilweise als Strangpressprofile und teilweise als Trennbleche ausgebildet, die miteinander verlötet sind. Die als Trennbleche ausgebildeten Kühlrippen 130 sind dabei bevorzugt als beidseitig lotplattierte Bleche ausgebildet. Die die Grundplatte bildenden verdickten Enden 111 sind dabei an den als Strangpressprofil ausgebildeten Kühlrippen 110 angeformt.

Wie des Weiteren in den Figuren 1 bis 4 erkennbar ist, sind an den als Strangpressprofil ausgebildeten Kühlrippen 110 in Kühlluft-Strömungsrichtung x sich erstreckende Stege 113, 114 im die Kühlluftkanäle 140 bildenden Bereich 112 der Kühlrippen 110 angeformt, die an jeweiligen Seitenflächen der als Trennbleche ausgebildeten Kühlrippen 130 anliegen, so dass die als Strangpressprofile ausgebildeten Kühlrippen 110 im Bereich der Stege 113, 114 ebenfalls mit dem als Trennbleche ausgebildeten Kühlrippen 130 verlötet sind.

Diese Stege 113, 114 sind dabei bevorzugt beidseits des die Kühlluftkanäle 140 bildenden Bereiches 112 der als Strangpressprofil ausgebildeten Kühlrippen 110 vorgesehen und dienen dabei neben der Wärmeübertragung zusätzlich dazu, gleichmäßige Abstände zwischen den einzelnen Kühlrippen 110, 130 zu gewäh rleisten.

Um ein zuverlässiges Verlöten der Stege 113, 114 mit den als Trennblechen ausgebildeten Kühlrippen 130 zu gewährleisten, sind bevorzugt mehrere Stege 113, 114 vertikal in einem Abstand a voneinander beabstandet an den Seitenflächen der Kühlrippen 110 angeformt. Zum Ausgleich von baubedingten Toleranzen sind die Stege 113, 114 um einen halben Abstand a versetzt zueinander wechselseitig an den Seitenflächen der Kühlrippen 110 angeformt.

Die Länge l₁₁₃, l₁₁₄ dieser Stege senkrecht zur Kühlluft-Strömungsrichtung x in Richtung der Breite y des Kühlkörpers 100 ist dabei bevorzugt größer als die halben Differenz der Dicke d₁₁₁ des verdickten Endes 111 der als Strangpressprofil ausgebildeten Kühlrippen 110 und der Dicke d₁₁₂ des Kühlluftkanäle 140 bildenden Bereiches 112 der als Strangpressprofil ausgebildeten Kühlrippen 110. Dadurch werden beim Zusammenbau des Kühlkörpers 100 die als Trennbleche 130 ausgebildeten Kühlrippen 130 geringfügig verformt, jedoch wird dadurch sichergestellt, dass auch bei Toleranzen bei der Herstellung der Strangpressprofile in jedem Fall die Stege an den Trennblechen anliegen und somit eine Lötverbindung erzeugbar ist.

Bei der in Figur 2 gezeigten Ausführungsvariante des erfindungsgemäßen Kühlkörpers ist in einem vorderer Teil der als Trennbleche ausgebildeten Kühlrippen 130 im die Kühlluftkanäle 140 bildenden Bereich 132 ein Teilstück weggeschnitten und sorgt so für eine Verringerung des Druckverlustes des Kühlkörpers 100, ohne die Kühlleistung des Kühlkörpers 100 wesentlich zu schwächen. Dabei können je nach Anforderung an den Druckverlust bzw. Wärmeübertragungsleistung als Trennbleche ausgebildeten Kühlrippen 130 in Kühlluftströmungsrichtung x unterschiedlich weit ausgeschnitten sein und/oder ausgeschnittene und nicht ausgeschnittene Trennbleche alternierend angeordnet sein.

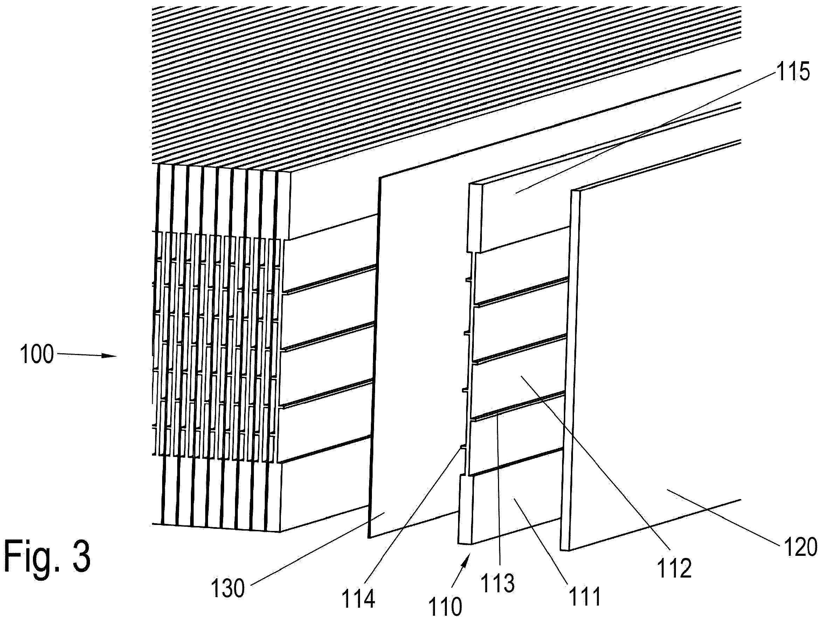

Bei der in Figur 3 gezeigten Ausführungsvariante des Kühlkörpers 100 sind sowohl das untere Ende der als Strangpressprofile ausgebildeten Kühlrippen 110 als auch das obere Ende 115 verdickt ausgebildet, so dass mit derart ausgebildeten Kühlrippen 110, 130 ein Kühlkörper 100 mit einer oberen und einer unteren Grundplatte herstellbar ist.

Vorteilhaft bei den in den Figuren 1 bis 4 gezeigten Kühlkörpern 100 ist, dass die Grundplatte beziehungsweise Grundplatten aus stoffschlüssigen Verbindungen zwischen den einzelnen Kühlrippen 110, 130 zusammengesetzt sind, welche für eine sehr gute Wärmeübertragung sorgen und mechanisch sehr robust sind.

Bei der Herstellung der in Figur 2 gezeigten Ausführungsvariante des Kühlkörpers 100 ist es außerdem vorteilhaft, dass die bei dieser Variante verbauten als Trennbleche ausgebildeten Kühlrippen 130 durch einfaches Ausstanzen eines gewünschten Bereichs der Trennbleche sehr kostengünstig herstellbar ist.

### Bezugszeichenliste

- 1: Bauelement

- 100: Kühlkörper
- 110: Kühlrippen
- 111: erstes Ende
- 112: Bereich
- 113: Steg
- 114: Steg
- 115: oberes Ende

- 130: Kühlrippen
- 131: erstes Ende
- 132: Bereich

- 140: Kühlluftkanal

- a: Abstand
- d₁₁₁: Dicke
- d₁₁₂: Dicke

- l₁₁₃: Länge
- l₁₁₄: Länge

- x: Kühlluftströmungsrichtung

## Patentansprüche

1. Kühlkörper (100) für mindestens ein zu kühlendes Bauelement (1), insbesondere ein Halbleiterbauelement, aufweisend mehrere nebeneinander angeordnete, Kühlluftkanäle (140) bildende Kühlrippen (110, 130), die mit jeweiligen ersten Enden (41, 51) eine Grundplatte bilden, wobei zumindest einige der Kühlrippen (110, 130) ein gegenüber einem die Kühlluftkanäle (140) bildenden Bereich (112) verdicktes erstes Ende (111) aufweisen, **dadurch gekennzeichnet, dass** ein Teil der Kühlrippen (110) als Strangpressprofil und die übrigen Kühlrippen (130) als Trennbleche ausgebildet sind, wobei die Strangpressprofile und die Trennbleche (130) miteinander verlötet sind und wobei an den als Strangpressprofil ausgebildeten Kühlrippen (110) in Kühlluftströmungsrichtung (x) sich erstreckende Stege (113, 114) im die Kühlluftkanäle (140) bildenden Bereich (112) angeformt sind, die an jeweiligen Seitenflächen der als Trennbleche ausgebildeten Kühlrippen (130) anliegen.

2. Kühlkörper (100) nach Anspruch 1, **dadurch gekennzeichnet, dass** die Stege (113, 114) um einen halben Abstand (a) zueinander versetzt wechselseitig an den als Strangpressprofil ausgebildeten Kühlrippen (110) angeformt sind.

3. Kühlkörper (100) nach Anspruch 1 oder 2, **dadurch gekennzeichnet, dass** die Länge (l₁₁₃, l₁₁₄) der Stege (113, 114) senkrecht zur Kühlluftströmungsrichtung (x) größer ist als die Hälfte der Differenz der Dicke (d₁₁₁) des verdickten Endes (111) der als Strangpressprofil ausgebildeten Kühlrippen (110) und der Dicke (d₁₁₂) des Kühlluftkanäle (140) bildenden Bereiches (112) der als Strangpressprofil ausgebildeten Kühlrippen (110).

4. Kühlkörper (100) nach einem der vorstehenden Ansprüche, **dadurch gekennzeichnet, dass** die die Kühlluftkanäle (140) bildenden Bereiche der als Trennbleche ausgebildeten Kühlrippen (130) im Kühllufteintrittsbereich des Kühlkörpers (100) zumindest teilweise weggeschnitten sind.

5. Kühlkörper (100) nach einem der vorstehenden Ansprüche, **dadurch gekennzeichnet, dass** zumindest einige der Kühlrippen (110, 130) ein gegenüber dem die Kühlluftkanäle (140) bildenden Bereich (112) verdicktes zweites Ende (115) aufweisen.
